# EUROPÄISCHE PATENTANMELDUNG

(11) **EP 1 365 264 A2**
(43) Veröffentlichungstag der Anmeldung: **26.11.2003**
(21) Anmeldenummer: 03017713.3
(22) Anmeldetag: 22.10.1999
(51) Int. Cl.: G02B 5/30

(54) **Polarisationsoptisch kompensiertes Objektiv**

(30) Priorität: 10.11.1998 DE 19851749
(62) Teilanmeldung aus: 99121104.6
(71) Anmelder: Carl Zeiss SMT AG, 73447 Oberkochen (DE)
(72) Erfinder: Schuster, Karl-Heinz, 89551 Königsbronn (DE)
(74) Vertreter: Gnatzig, Klaus

(57) **Zusammenfassung**

Bei einem Objektiv - vorzugsweise ein katadioptrisches Projektionsobjektiv der Mikrolithographie - werden polarisationsabhängige Effekte hinsichtlich Strahl-Geometrie und Phase, wie sie durch die unterschiedliche Reflexion in Abhängigkeit von der Polarisationsrichtung bezogen auf die Reflexionsebene entstehen können, durch Anpassung dielektrischer Reflexschichten kompensiert.

## Beschreibung

Zur Belichtung von Mikrostrukturen mit hoher Auflösung in Resists sind hohe numerische Aperturen (z.B. 0,6-0,8) vorteilhaft.

Dabei ist es dann zur Vermeidung störender Reflexionen und anderer Störungen erforderlich, daß die Polarisation der Lichtstrahlen bezüglich der optischen Achse rotationssymmetrisch ist. Geeignet sind also radiale Polarisation (vgl. DE 195 35 392) - und auch zirkulare Polarisation, sowie unpolarisiertes Licht.

Linear polarisiertes Licht wird generell als ungeeignet angesehen, da es richtungsabhängige Effekte bewirkt. Ausnahmen sehen die gezielte Anpassung der Polarisationsrichtung an die Strukturrichtung vor.

Umlenkspiegel zeigen für in der Einfallsebene polarisiertes und senkrecht dazu polarisiertes Licht einen Versatz des austretenden Lichtstrahls und Phasenverschiebungen durch unterschiedliche Wechselwirkung des elektromagnetischen Feldes mit der spiegelnden Grenzfläche.

Katadioptrische Projektionsobjektive mit Strahlteiler vom Typ der DE 196 39 586 A (US Serial No. 08/929,913) und darin angegebener Zitate haben dies Problem nicht, da ohnehin wegen des Polarisationsstrahlteilers linear polarisiertes Licht verwendet werden muß (und erst danach die Polarisation z.B. mit einer Lambdaviertelplatte geändert werden kann).

Anders ist das beispielsweise bei den katadioptrischen Projektionsobjektiven vom Typ des abgewandelten Schupmann-Achromaten u.a. nach EP 0 736 789 A2.

Beispielsweise zeigt EP 0 736 789 A2 in Figur 6 und 9 je zwei Umlenkspiegel (M₀, M₂; M₂, M₃), wobei einer (M₂; M₂) zur Separation der zu dem Konkavspiegel (M₁) gehenden und davon zurücklaufenden Lichtbündel dient und der andere (M₀; M₃) die Parallellage von Reticle und Wafer ermöglicht. Werden diese Spiegel mit einer Mischung von in der Einfallsebene und senkrecht dazu polarisiertem Licht - also z.B. mit unpolarisiertem, zirkular oder elliptisch polarisiertem oder radial polarisiertem - beleuchtet, so ergibt die Umlenkung um rund 90° jeweils einen Seitenversatz der den beiden Polarisationsrichtungen zugeordneten Strahlanteile, der sich bei beiden Spiegeln additiv auswirkt. Folge davon sind Gangunterschiede und Lageverschiebungen der das Bild am Wafer erzeugenden Strahlenbündel und damit eine Verschlechterung des Bildes.

Der Effekt ist zwar klein, spielt aber bei den Auflösungen im Bereich unter 0,5 µm und den Wellenlängen im DUV, für den derartige katadioptrische Projektionsobjektive vorgesehen sind, schon eine störende Rolle.

Auch am Konkavspiegel tritt der Effekt prinzipiell auf, wegen der wesentlich kleineren Umlenkwinkel bleibt er aber sehr klein.

Aufgabe der Erfindung ist es, die Abbildungsqualität eines Objektivs mit Umlenkspiegel unabhängig von den Polarisationseigenschaften des Lichts zu machen, insbesondere rotationssymmetrische Verteilungen der Polarisation zuzulassen. Dies gilt besonders für Projektionsobjektive im DUV.

Gelöst wird diese Aufgabe durch ein katadioptrisches Objektiv nach Anspruch 1.

Die Erfindung geht aus von der Erkenntnis, daß die Polarisationseffekte an Umlenkspiegeln bei der Abbildungsleistung hochwertiger Objektive, insbesondere mikrolithographischer Projektionsobjektive, nicht unberücksichtigt bleiben können. Phasenverschiebung und Seitenversatz für gegenüber der Einfallsebene am Umlenkspiegel verschieden polarisiertes Licht sind zu berücksichtigen, da sie zu erheblichen Bildstörungen führen können.

Mindestens im Strahlengang vom letzten Objektivelement zur Bildebene ist aber - hauptsächlich bei großen numerischen Aperturen von 0,5 und darüber - eine zur optischen Achse rotationssymmetrische Polarisation (radiale, zirkuläre) notwendig, da sonst die Einkopplung in den Lichtempfänger (Resist) azimutal variiert.

Zur Kompensation der Polarisationseffekte stehen windschiefe Paarungen der Spiegel und phasenkorrigierende dielektrische Schichten zur Verfügung.

An den bei katadioptrischen Systemen Korrektur- und Abbildungs-wirksam gekrümmten Spiegeln liegen regelmäßig kleine Ablenkwinkel vor, bei denen dieser Polarisations-Störeffekt geringfügig bleibt. Anders ist dies jedoch bei Umlenkspiegeln.

Den gleichen Erfindungsgedanken in verschiedenen vorteilhaften Ausformungen spiegeln die nebengeordneten Ansprüche 2 bis 5 und 11 wieder. Vorteilhafte Ausführungsformen sind Gegenstand der Unteransprüche 6 bis 10 und 12 bis 15. Diese betreffen insbesondere die Ausbildung als DUV-Mikrolithographie-Projektionsobjektiv mit Zwischenbild vom abgewandelten Schupmann-Achromat-Typ, bei dem die Erfindung besonders vorteilhaft zur Anwendung kommt.

Eine derartige Projektionsbelichtungsanlage ist Gegenstand des Anspruches 16, vorteilhafte Weiterbildungen davon sind in den Ansprüchen 17 bis 20 wiedergegeben. Wichtig ist dabei die Freiheit in der Wahl des Polarisationszustands des Lichts im Projektionsobjektiv.

Näher erläutert wird die Erfindung anhand der Zeichnung. Diese zeigt in
- Figur 1: schematisch ein Objektiv mit windschiefen Umlenkspiegeln;
- Figur 2a, 2b: zwei Ansichten eines Prismas mit windschiefen Umlenkflächen;
- Figur 3: schematisch ein Objektiv mit Phasenkorrektur-Spiegelbeschichtung; und
- Figur 4: zeigt schematisch eine erfindungsgemäße Projektionsbelichtungsanlage.

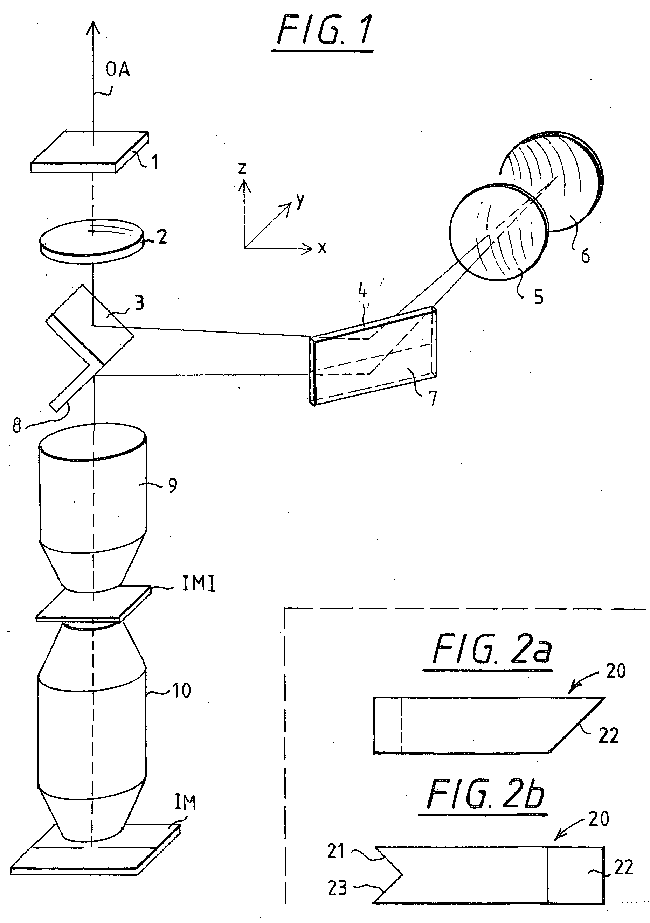

Die Zeichnung Figur 1 zeigt eine Objektebene 1, in der eine Maske (Retikel) der Mikrolithographie angeordnet werden kann, eine Linse 2, einen ersten planen Umlenkspiegel 3, einen zweiten planen Umlenkspiegel 4, eine Linsengruppe 5, einen Konkavspiegel 6, einen dritten planen Umlenkspiegel 7 - dieser kann mit dem Umlenkspiegel 4 komplanar vereinigt sein -, einen vierten planen Umlenkspiegel 8, eine zweite Linsengruppe 9, eine Zwischenbildebene IMI, eine vierte Linsengruppe 10 (refraktives Teilobjektiv) und die Bildebene IM, in der der zu belichtende Wafer mit einer Resistschicht angeordnet werden kann.

Bis auf die Umlenkspiegel 4 und 7 entspricht die Anordnung einem katadioptrischen Objektiv der oben genannten Art, z.B. der EP 0 736 789 A2.

Erfindungsgemäß sind jedoch die Umlenkspiegel 4 und 7 angeordnet, deren Einfallsebenen nicht komplanar sind mit den planen Umlenkspiegeln 3 und 8. Vorzugsweise sind die Einfallsebenen der Umlenkspiegel 4 und 7 senkrecht zu den Einfallsebenen der Umlenkspiegel 3 und 8. Das Licht durchläuft also nacheinander drei nicht komplanare, vorzugsweise zueinander senkrechte Richtungen. Durch die dementsprechenden Umlenkungen wird die oben beschriebene Kompensation polarisations-abhängiger Effekte an den Umlenkspiegeln 3, 4, 7, 8 bewirkt und das Objektiv kann mit Licht beliebiger Polarisation betrieben werden.

Vorzugsweise, zur Erleichterung der Herstellung und Justage, werden die beiden Spiegel 4 und 7 als ein gemeinsames planes Teil ausgeführt.

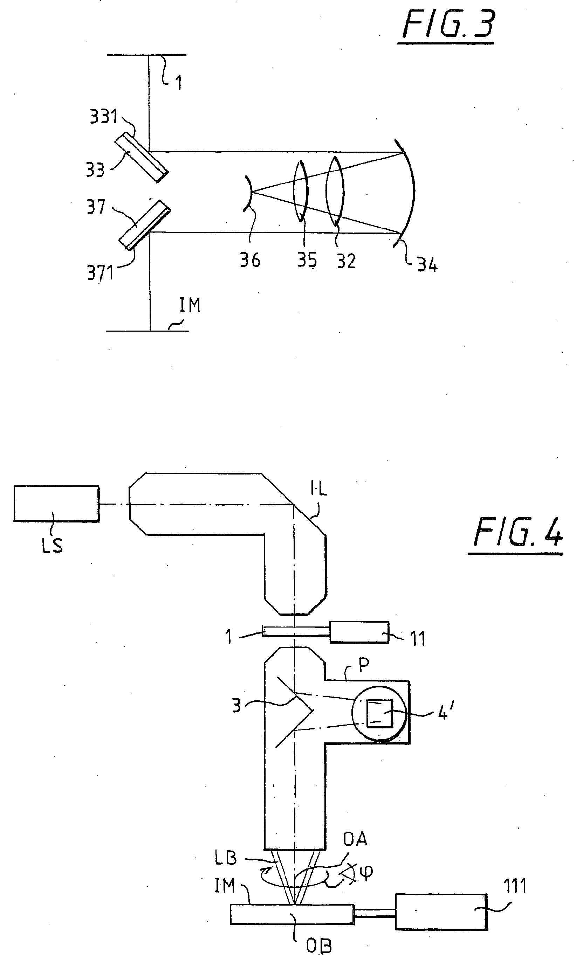

Die Figuren 2a und 2b zeigen Aufsicht und Seitenansicht eines Porro-Prismas 20, das mit seinen reflektierenden Flächen 21 und 23 die Umlenkspiegel 3 und 8 und mit der Fläche 22 die Umlenkspiegel 4 und 7 substituieren kann. Die reflektierenden Flächen 21, 22, 23 sind vorzugsweise mit einer Schutzschicht versehen.

Figur 3 zeigt ein katadioptrisches Objektiv vom Offner-Typ, wie es als 1:1 Projektionsobjektiv in der Mikrolithographie eingeführt ist. Auch dieses weist zwei plane Umlenkspiegel 33, 37 auf, welche für eine praktisch vorteilhafte Anordnung von Objektebene 1 und Bildebene IM und-optischem System, bestehend aus Linsengruppen 32, 35 und gekrümmten Spiegeln 34, 36, sorgen.

An sich bekannte phasenkorrigierende dielektrische dünne Schichten 331, 371 ergeben hier eine Kompensation polarisations-spezifischer Effekte bei der Reflexion an den Umlenkspiegeln 33, 37, ohne daß zusätzliche spiegelnde Elemente eingebaut werden müssen.

Diese phasenkorrigierenden Schichten sind jedoch schwierig herzustellen für große Strahldivergenzen und kleine Wellenlängen. Je nach Bedeutung dieser Parameter wird der Fachmann also die Ausführung mit zusätzlichen windschiefen Umlenkspiegeln (bzw. Porro-Prismen) nach den Figuren 1 oder 2a, 2b bevorzugen.

Figur 4 gibt einen schematischen Überblick über eine erfindungsgemäße Projektionsbelichtungsanlage. Eine Lichtquelle LS - bevorzugt ein Excimer-Laser im DUV-, eine Beleuchtungsoptik IL, ein Retikel 1 mit Halter und Justier/Scan-Einheit 11 bekannter Art werden mit einem erfindungsgemäßen Projektionsobjektiv P mit planem Umlenkspiegel 3 und Kompensationsspiegel 4' verbunden und erzeugen in der Bildebene IM auf einem Objekt OB - z.B. einem Wafer für mikroelektronische Schaltungen - ein Belichtungsmuster. Das Objekt OB ist ebenfalls verbunden mit einer Halte-, Justage- und Scaneinheit 111.

Aus dem Projektionsobjektiv P tritt das bildgebende Lichtbündel LB unter Azimutwinkeln ϕ aus. Für die Belichtung ist es vorteilhaft, wenn die Polarisation des Lichts unter jedem Azimutwinkel ϕ bezogen auf die Einfallsebene zum Objekt OB gleich ist. Dies wird mit einer erfindungsgemäßen Kompensation der Polarisationseigenschaften des Umlenkspiegels 3 - im Beispiel durch den Umlenkspiegel 4' - ermöglicht.

Die erfindungsgemäße Anordnung eignet sich besonders für kleinste Strukturen im Submikrometer-Bereich für hochaperturige Objektive (NA > 0,5). Auch unter den dann steilen Auftreffwinkeln am Objekt werden Unregelmäßigkeiten der Lichteinkopplung vermieden.

## Patentansprüche

1. Objektiv mit mindestens einem Umlenkspiegel (33) oder einem Umlenkprisma mit dünnen Schichten (331), **dadurch gekennzeichnet, daß** die dünnen Schichten (331) hinsichtlich Strahl-Geometrie und Phase gleiche Reflexion von in der Einfallsebene und senkrecht dazu polarisiertem Licht bewirken.

2. Objektiv nach Anspruch 1, **dadurch gekennzeichnet, daß** es unabhängig vom Polarisationszustand des einfallenden Lichts hinsichtlich Strahlgeometrie und Phase gleiche Eigenschaften aufweist.

3. Objektiv nach mindestens einem der Ansprüche 1-2, **dadurch gekennzeichnet, daß** das Objektiv ein katadioptrisches Objektiv ist.

4. Objektiv nach mindestens einem der Ansprüche 1-3, **dadurch gekennzeichnet, daß** das Objektiv ein Zwischenbild aufweist.

5. Objektiv nach mindestens einem der Ansprüche 1-4, **dadurch gekennzeichnet, daß** es vom Typ abgewandelter Schupmann-Achromat ist.

6. Objektiv nach mindestens einem der Ansprüche 1-5, **dadurch gekennzeichnet, daß** es als Projektionsobjektiv der Mikrolithographie für DUV-Licht ausgebildet ist, insbesondere für Wellenlängen von 100-250 nm.

7. Objektiv nach mindestens einem der Ansprüche 1-6, **dadurch gekennzeichnet, daß** es eine bildseitige numerische Apertur größer als 0,5, vorzugsweise größer als 0,6 aufweist.

8. Objektiv nach mindestens einem der Ansprüche 1-7, **gekennzeichnet durch** die Kompensation polarisationspezifischer Effekte bei der Spiegelung am Umlenkspiegel (3).

9. Objektiv nach mindestens einem der Ansprüche 1-8, **dadurch gekennzeichnet, daß** polarisationspezifischer Seitenversatz kompensiert wird.

10. Objektiv nach mindestens einem der Ansprüche 1-9, **dadurch gekennzeichnet, daß** der Umlenkspiegel polarisationspezifische dünne Schichten trägt.

11. Projektionsbelichtungsanlage der Mikrolithographie mit einem Projektionsobjektiv (P), welches nach mindestens einem der Ansprüche 1 bis 10 ausgeführt ist.

12. Projektionsbelichtungsanlage nach Anspruch 11, **dadurch gekennzeichnet, daß** Licht im Projektionsobjektiv (P) nicht linear polarisiert ist und der Polarisationszustand der aus dem Projektionsobjektiv (P) auf dem Bildfeld (IM) austretenden Lichtbündel (LB) für alle Azimutwinkel (ϕ) bezogen auf die Einfallsebene gleich ist.

13. Projektionsbelichtungsanlage nach Anspruch 11 oder 12, **dadurch gekennzeichnet, daß** das Licht im Projektionsobjektiv (P) unpolarisiert ist.

14. Projektionsbelichtungsanlage nach Anspruch 11 oder 12, **dadurch gekennzeichnet, daß** das Licht im Projektionsobjektiv (P) radial polarisiert ist.

15. Projektionsbelichtungsanlage nach Anspruch 11 oder 12, **dadurch gekennzeichnet, daß** das Licht im Projektionsobjektiv (P) zirkular polarisiert ist.
